# EUROPEAN PATENT APPLICATION

(11) **EP 3 813 092 A1**
(43) Date of publication of application: **28.04.2021**
(21) Application number: 20201736.4
(22) Date of filing: 14.10.2020
(51) Int. Cl.: H01J 37/32

(54) **PLASMA SOURCE**

(30) Priority: 23.10.2019 JP 2019192663; 16.04.2020 JP 2020073434
(71) Applicant: EMD Corporation, Shiga 520-2323 (JP)
(72) Inventor: Ebe, Akinori, Shiga, Shiga 520-2323 (JP)
(74) Representative: Hoeger, Stellrecht & Partner Patentanwälte mbB

(57) **Abstract**

An inductively coupled plasma source (10) with a simple configuration, has an antenna cooling mechanism capable of reducing costs required for such devices. The plasma source is configured to generate plasma in a vacuum vessel (21), and includes a frame (12; antenna fixing frame) provided in a wall (211) of the vacuum vessel and a surface antenna (11) fixed in the frame. The periphery of the antenna is surrounded by the frame, so that heat generated in the antenna flows from the periphery to the frame and further flows from the frame to the vacuum vessel. Thus, the antenna is efficiently cooled. Therefore, a liquid or gas refrigerant is unnecessary, and thus the configuration can be simplified. Furthermore, a temperature control device and a circulation device are unnecessary, so that the cost required for the devices is reduced.

## Description

### TECHNICAL FIELD

The present invention relates to an inductively coupled plasma source.

### BACKGROUND ART

In the inductively coupled plasma sources, gas is introduced in a space where the plasma is to be generated, and a radio-frequency current is applied to an antenna located in that space or in the vicinity of that space to generate a radio-frequency electromagnetic field in the space for making molecules of the gas be ionized in cations and electrons, whereby plasma is generated. When plasma is produced, Joule heat is generated due to the radio-frequency current that flows in the antenna. Thus, it is necessary to cool the antenna. Patent Literature 1 discloses that a tube made of conductive material is used as an antenna, and gas or liquid coolant flows through the tube to thereby cool the antenna. The antenna is attached to a lid made of metal (stainless steel, for example) via feedthroughs, and the lid is fixed to a wall of a vacuum vessel to close an opening provided in the wall, whereby the antenna is attached to the vacuum vessel.

### CITATION LIST

### PATENT LITERATURE

Patent Literature 1: JP 2010-212105 A

### SUMMARY OF INVENTION

### TECHNICAL PROBLEM

In the plasma source disclosed in Patent Literature 1, electrodes for introducing radio-frequency current should be connected to the opposite ends of the antenna which is a tube made of conductive material, and other tubes for flowing gas refrigerant or liquid refrigerant should also be connected to the antenna tube. This makes the configuration of the plasma source be complicated. In addition, it is further necessary to prepare a device for controlling the temperature of the refrigerant, and a circulation system if the refrigerant is used in circulation. As such, additional costs for such devices are incurred.

A problem to be solved by the present invention is to provide an inductively coupled plasma source having an antenna cooling mechanism that can reduce cost with a simple configuration.

### SOLUTION TO PROBLEM

The present invention developed for solving the previously described problem is a plasma source for generating plasma in a vacuum vessel. The plasma source includes:
a) a frame provided in a wall of the vacuum vessel, and
b) a surface antenna fixed in the frame.

In the plasma source according to the present invention, heat generated in the surface antenna is guided to the vacuum vessel, which is a heat bath, via the frame to which the antenna is fixed. Thus, the antenna is cooled. The periphery of the surface antenna is surrounded by the frame, so that the heat generated in the antenna flows out from its periphery to the frame and further flows out from the frame to the vacuum vessel. Thus, the antenna is efficiently cooled. Therefore, a liquid or gas refrigerant is not needed, so that the configuration can be simplified. Furthermore, a temperature control device or a circulation system is unnecessary, so that the cost required for such devices can be reduced.

In a regular plasma processing apparatus, the vacuum vessel is formed of a metal member having a large mass. Accordingly, it is possible to absorb the heat generated in the antenna by such a large metal member (heat bath or heat capacitance). Therefore, it is possible to reduce the heat that may be transferred to a power source that supplies current to the antenna.

For the material of the frame, it is preferable to use metal because of its high thermal conductivity. Other than metal, a material having high thermal conductivity, such as aluminum nitride (AlN), may also be used.

In the plasma source according to the present invention, the frame and the antenna may be provided in a lid that closes an opening of the vacuum vessel. Alternatively, the frame and the antenna themselves may be used as the lid for the opening. With this configuration, the surface antenna is provided in the opening of the vacuum vessel, whereby the heat generated in the antenna can be conducted to the vacuum vessel through the frame, and the heat can also be radiated from the outer face of the antenna to the exterior of the vacuum vessel. Therefore, the antenna can be efficiently cooled.

When the frame and the antenna are provided in the lid, it is preferable for the plasma source to have a dielectric window which is a plate member made of a dielectric material and provided on a face of the antenna facing an inside of the vacuum vessel. With this configuration, the antenna is protected from the plasma generated in the vacuum vessel. Although the dielectric window receives heat from the plasma, in the present invention, such heat is transferred to the vacuum vessel through the antenna and the frame. The thickness of the dielectric window should preferably be small, for example, 5 mm or less, for the antenna to produce as strong radio-frequency electromagnetic field as possible in the vacuum vessel without attenuating its intensity.

When the dielectric window is located to face the inside of the vacuum vessel, it is preferable for the plasma source to have a vacuum seal located between the wall around the opening and the dielectric window. With this configuration, the opening is closed in an airtight manner by the dielectric window and the vacuum seal.

When the dielectric window is located to face the inside of the vacuum vessel, it is preferable that the space between the antenna and the dielectric window is filled with an adhesive made of a dielectric material. With this configuration, the tightness between the antenna and the dielectric window is enhanced in comparison with the case where they are directly in contact with each other. Since the dielectric window and the adhesive, as well as the adhesive and the antenna are respectively contacted, the heat received by the dielectric window from the plasma is efficiently transferred to the antenna via the adhesive (the heat transferred to the antenna flows into the vacuum vessel via the frame as mentioned earlier). For such an adhesive, resin adhesives including silicone resin, epoxy resin, and Teflon (registered trademark) resin, and adhesives containing fritted glass are preferably used. However, the adhesive is not limited to these examples.

When the frame and the antenna are provided in the lid, it is preferable for the plasma source to have an insulation plate which is a plate member made of an insulator, and is in contact with the frame. With this configuration, the pressure difference between the inside of the vacuum vessel and the atmosphere is received by the insulation plate, and the antenna and the frame are electrically insulated. The heat of the antenna flows to the frame via the insulation plate. Thus, the insulation plate is preferably made of a material having high level of thermal conductivity, such as AlN.

When the insulation plate is provided, it is preferable that the space between the antenna and the insulation plate be filled with an adhesive made of a dielectric material. Accordingly, the heat generated in the antenna is efficiently transferred to the insulation plate via the adhesive, as in the case where the space between the antenna and the dielectric window is filled with the adhesive. For the adhesive used in this case, resin adhesives including silicone resin, epoxy resin, and Teflon resin, and adhesives containing glass, such as fritted glass, can be preferably used. However, the adhesive is not limited to these examples.

In the surface antenna, the radio-frequency current flows only in the vicinity of the inner and outer face of the antenna due to the skin effect. Thus, an increase in the thickness of the antenna causes the material to be wasted. Therefore, the thickness of the antenna is preferably thin to the extent that the mechanical strength is maintained. For example, the thickness may be 1 to 1000 µm. It should be noted that the shape of the antenna is not limited to the plane (flat) shape, but may be a curved shape. Furthermore, the surface antenna may be flexible.

### ADVANTAGEOUS EFFECTS OF INVENTION

According to the present invention, the configuration of the cooling mechanism of an antenna in an inductively coupled plasma source can be simplified, so that the cost required for such devices can be reduced.

### BRIEF DESCRIPTION OF DRAWINGS

Fig. 1A is a schematic configuration diagram showing a plasma processing apparatus including a plasma source according to the first embodiment of the present invention, and Fig. 1B is a partially enlarged view showing the plasma source and its surroundings.
Fig. 2 is a diagram showing, with arrows, heat flow in the plasma source according to the first embodiment.
Fig. 3 is a diagram showing, with arrows, flow of electric current in an antenna in the plasma source according to the first embodiment.
Fig. 4 is a graph showing the respective electron densities of plasma generated in the plasma source according to the first embodiment and a conventional plasma source which uses an antenna made of a conductive tube.
Fig. 5 is a schematic configuration diagram showing a plasma source according to the second embodiment of the present invention.
Fig. 6 is a diagram showing, with arrows, heat flow in the plasma source according to the second embodiment.
Figs. 7A to 7D are graphs respectively showing the measurement results of temperature change during plasma lighting in: the antenna (7A); the first insulation member (7B); the second insulation member (7C); and the dielectric window (7D).

### DESCRIPTION OF EMBODIMENTS

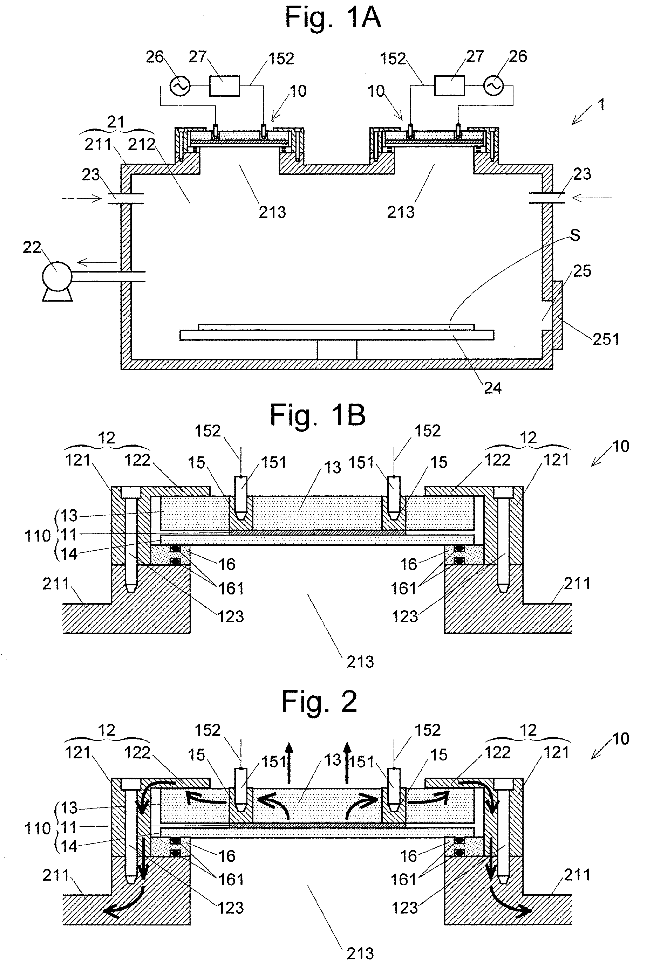

Embodiments of the plasma source according to the present invention are described, with reference to Figs. 1 to 7.

### (1) Configuration of plasma source according to first embodiment

Fig. 1A is a schematic configuration diagram of a plasma processing apparatus 1 including a plasma source 10 according to the first embodiment, and Fig. 1B is a partially enlarged view of the plasma source 10. The plasma processing apparatus 1 is a film formation apparatus using a plasma chemical-vapor-deposition (CVD) method, and includes, in addition to the plasma source 10, a vacuum vessel 21, a vacuum pump 22, a gas supplier 23, a substrate holder 24, a substrate carrying in/out port 25, a radio-frequency power source 26, and an impedance matching unit 27.

First, structural elements of the plasma processing apparatus 1, except for the plasma source 10, are described. The vacuum vessel 21 has a wall 211 made of metal (stainless steel, for example) for defining an inner space 212 enclosed by the wall 211, in which plasma is generated. The vacuum pump 22 evacuates the inner space 212. The gas supplier 23 includes a gas source (not shown) and a gas introduction tube, for supplying into the inner space 212 plasma generation gas, such as argon gas or hydrogen gas, and film-formation material gas. When processing that does not use the film-formation material gas is performed on the substrate S, such as film formation by sputtering or washing the substrate S, only plasma generation gas is supplied to the inner space 212 from the gas supplier 23. The substrate holder 24 holds the substrate S. The substrate carrying in/out port 25 is provided in the wall 211 for allowing the substrate S to pass therethrough when the substrate S is carried from the exterior of the vacuum vessel 21 to be set on the substrate holder 24 before the film formation, and when the substrate S is carried out to the exterior of the vacuum vessel 21 from the substrate holder 24 after the film formation. The substrate carrying in/out port 25 is tightly closed by a lid 251 when the substrate S is not carried in or out. The radio-frequency power source 26 supplies radio-frequency current to an antenna 11 which will be described later. The impedance matching unit 27 is provided for adjusting impedance so that the radio-frequency current from the radio-frequency power source 26 is efficiently introduced in the antenna 11.

In the present embodiment, a single plasma processing apparatus 1 includes two plasma sources 10. Here, the number of the plasma sources 10 is not limited to two, but may be only one, or three or more. Each plasma source 10 includes an antenna 11, an antenna fixing frame (the aforementioned frame) 12, a plate-shaped insulation member 13, a plate-shaped dielectric window 14, two radio-frequency current supply bars 15, and an airtight holder 16.

In the present embodiment, a surface antenna formed of a metal plate is used for the antenna 11. Here, copper is used for the material of the antenna 11, but any other conductive material can be used than copper. Two radio-frequency current supply bars 15 are in contact with one of the faces of the antenna 11. The two radio-frequency current supply bars 15 are aligned substantially in parallel to each other, and are connected to the impedance matching unit 27 via a power-feed terminal 151 and a power-feed cable 152. The length of each of the radio-frequency current supply bars 15 is 30 mm, and the space between the two radio-frequency current supply bars 15 is 150 mm.

The insulation member 13 is in contact with the aforementioned one of the faces of the antenna 11 except for the areas with which the radio-frequency current supply bars 15 are in contact. The face of the insulation member 13 that is in contact with the antenna 11 is provided with cutouts for respectively receiving the radio-frequency current supply bars 15. The dielectric window 14 is in contact with the other face of the antenna 11. Accordingly, the antenna 11 is held between the insulation member 13 and the dielectric window 14. In other words, the insulation member 13, the antenna 11, and the dielectric window 14 are stacked in this order to form a stacked body 110. The stacked body 110 is placed so that the dielectric window 14 faces an opening 213 provided in the wall (upper wall) 211 of the vacuum vessel 21.

For the material of the insulation member 13, aluminum oxide, zirconium oxide, silicon nitride, aluminum nitride, and other similar materials may be used. Among these materials, the aluminum nitride has relatively high thermal conductivity, and thus can be preferably used. For the dielectric window 14, material similar to those for the insulation member 13 can be used.

The antenna fixing frame 12 includes a frame body 121 surrounding the side face of the stacked body 110, and a projection part 122 projecting from the frame body 121 over a part of a face of the insulation member 13 of the stacked body 110 to cover a part of this surface. When the insulation member 13 of the stacked body 110 is placed in the upper side, the antenna fixing frame 12 has an inverted L shape in a vertical cross-section of the stacked body 110. The frame body 121 is provided with holes penetrating the frame body 121 from its top face to its bottom face. The antenna fixing frame 12 is fixed by bolts 123 inserted through the holes to the wall (upper wall) 211 of the vacuum vessel 21 that surrounds the opening 213. The airtight holder 16 is located on the top face of the wall (upper wall) 121 in the inner side from the frame body 121. The stacked body 110 is vertically sandwiched and fixed by the projection part 122 and the airtight holder 16. The airtight holder 16 has a frame shape, the top and bottom faces of which are individually provided with a sealing member (O-ring) 161. The sealing member 161 on the top face is pressed by the dielectric window 14, and the sealing member 161 on the bottom face is pressed by the wall (upper wall) 211. With this configuration, the plasma source 10 functions as a lid for closing the opening 213 in an airtight manner.

It is preferable for the dielectric window 14 in the stacked body 110 to have a small thickness for enhancing the radio-frequency electromagnetic field generated in the inner space 212 of the vacuum vessel 21. Furthermore, in the antenna 11, the radio-frequency current flows only in the vicinity of the faces of the antenna 11 due to the skin effect. Thus, an increase in the thickness of the antenna 11 causes the material to be wasted. Meanwhile, the stacked body 110 is in contact with the inner space 212 of the vacuum vessel 21, which is in the vacuum state, at the dielectric window 14 side, and is also in contact with the ambient air at the insulation member 13 side. Accordingly, the stacked body 110 receives force caused by the difference in pressure between the vacuum and the atmospheric pressure. In view of this, it is necessary for the stacked body 110 to have mechanical strength to withstand the pressure difference. Thus, it is preferable for the insulation member 13 to have adequate thickness. However, if the thickness of the insulation member 13 increases too much, the efficiency in heat radiation in the antenna 11 decreases. Furthermore, the required mechanical strength depends on the size of the opening 213 of the vacuum vessel 21. In view of these factors, the thicknesses of the antenna 11, the insulation member 13, and the dielectric window 14 are determined. In the present embodiment, the opening 213 is a rectangular shape having a long side of 210 mm and a short side of 160 mm. The thicknesses of the antenna 11, the insulation member 13, and the dielectric window 14 are respectively 0.6 mm, 20 mm, and 3 mm. It is obviously possible to change each thickness appropriately. For example, the ranges of the thickness of the antenna 11, the insulation member 13, and the dielectric window 14 are respectively 1 to 1000 µm, 3 to 20 mm, and 5 mm or less. Here, the thickness of each member may be out of such ranges.

The plasma source 10 according to the present embodiment is not provided with a cooling mechanism for cooling the antenna 11 by circulating refrigerant.

### (2) Operation of plasma source according to first embodiment

Operation of the plasma source 10 according to the first embodiment is described together with operation of the plasma processing apparatus 1 provided with the plasma source 10.

First, the lid 251 of the substrate carrying in/out port 25 is opened, and the substrate S is carried in the inner space 212 of the vacuum vessel 21. Then, the substrate S is placed on the substrate holder 24 so as to be held by the substrate holder 24. Then, the lid 251 of the substrate carrying in/out port 25 is closed, and the inner space 212 of the vacuum vessel 21 is evacuated by the vacuum pump 22. The plasma generation gas and the film-formation material gas are supplied into the inner space 212 from the gas supplier 23. The radio-frequency current is introduced in the antenna 11 from the radio-frequency power source 26. Thus, a radio-frequency electromagnetic field is generated in the inner space 212, and molecules of the plasma generation gas are ionized to generate plasma. The generated plasma causes molecules of the film-formation material gas to be decomposed and deposited on the substrate S, whereby a film is formed.

During the film formation, flow of the radio-frequency current causes heat to be generated in the antenna 11. The heat thus generated passes through the insulation member 13 and the antenna fixing frame 12, and flows into the wall 211 of the vacuum vessel 21, as indicated by the arrows in Fig. 2. The periphery of the antenna 11 is surrounded by the antenna fixing frame 12, so that the heat generated in the antenna 11 can efficiently flow out from the periphery of the antenna 11 to the antenna fixing frame 12. The wall 211 of the vacuum vessel 21 has an adequately large heat capacity, and is in contact with the ambient air to cause heat radiation, whereby the heat is adequately released to thereby cool the antenna 11. At the cooling, it is not necessary to use a cooling mechanism by circulating refrigerant for cooling the antenna 11. Therefore, the initial cost and running cost of the apparatus is reduced by the plasma source 10 according to the present embodiment.

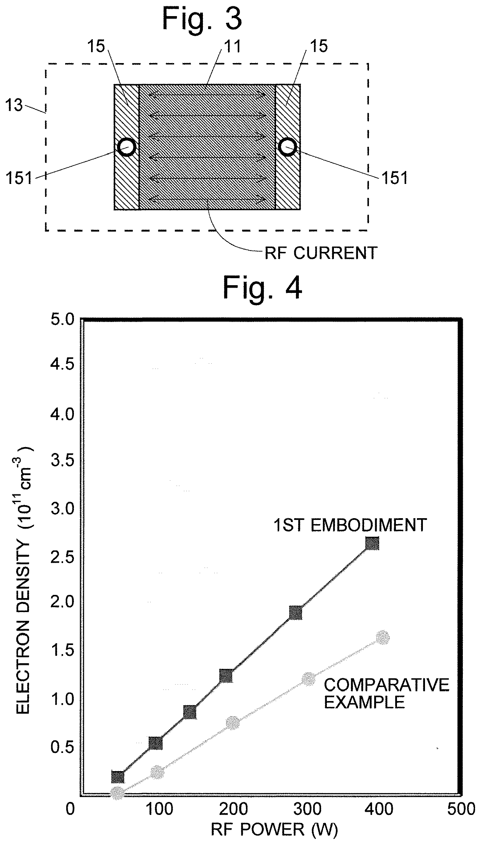

The surface antenna 11 is used in the present embodiment, and radio-frequency current is supplied between the two radio-frequency current supply bars 15 which are in contact with the surface of the antenna 11 and substantially in parallel to each other. Thus, the radio-frequency current flows in a widespread manner over the entire extent of the surface antenna as indicated by the arrows in Fig. 3. Accordingly, current greater than that which flows in a linear antenna can flow in the antenna 11 according to the present embodiment. Furthermore, the heat is also radiated to the atmosphere from the outer face of the surface antenna 11 via the insulation member 13, whereby the efficiency in heat release can be further enhanced.

Hereinafter, results of experiments are described in which the electron density of plasma generated using the plasma source of the first embodiment was measured. Results of comparative examples are also described, in which the electron density of the plasma generated with circulating refrigerant in a tube of a conventional tubular antenna formed of a conductive tube was also measured. The tubular antenna is shaped in a substantially U shape by being bent 90° at two positions spaced away from each other with a separation of 100 mm. In the experiments, a single plasma source according to the first embodiment was used, and a single tubular antenna was used in the comparative example. Argon gas as the plasma generation gas was introduced at the pressure of 1.0 Pa with the flow rate of 10 seem. Then, radio-frequency power was supplied to the antenna in the range of 50 to 400W, and the electron density of the plasma was measured using a Langmuir probe at a position separated from the antenna by 115 mm.

Results of the experiments are shown in Fig. 4. In both the first embodiment and the comparative example, the electron density increases in proportion to the increase in radio-frequency power. This means that the antenna is cooled without any difficulty both in the first embodiment and in the comparative example, even if the radio-frequency power is increased. Thus, in the configuration of the first embodiment in which no cooling mechanism using the refrigerant was equipped, the antenna can be cooled as in the comparative example in which the cooling mechanism was equipped. Therefore, a plasma source with a lower cost can be obtained. The electron density is higher in the first embodiment than that in the comparative example. A possible reason for this is that the inductance of the antenna in the first embodiment is smaller than that in the comparative example, and thus the radio-frequency current in the first embodiment is larger than that in the comparative example.

### (3) Configuration of plasma source according to second embodiment

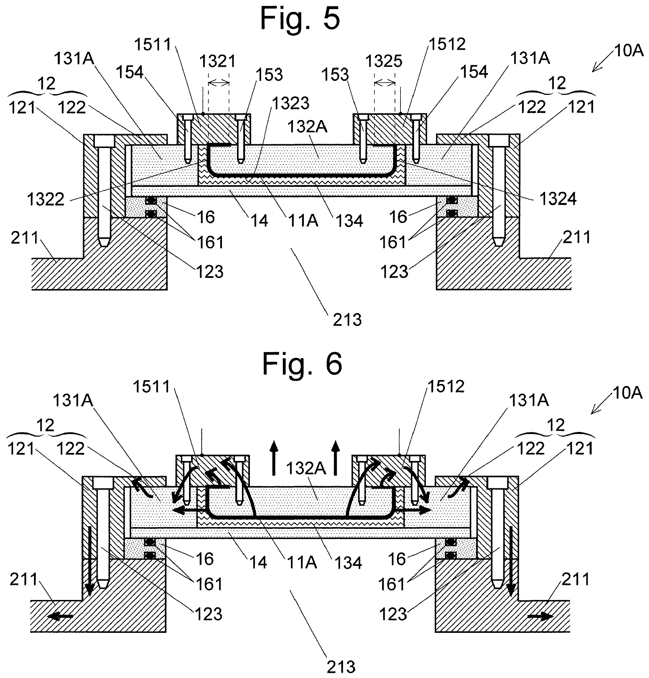

Fig. 5 shows a schematic configuration of a plasma source 10A according to the second embodiment. The plasma source 10A is attached to the wall 211 of the vacuum vessel 21 so as to close the opening 213 provided in the vacuum vessel 21 of the plasma processing apparatus 1, like the plasma source 10 of the first embodiment. Regarding the structural elements of the plasma processing apparatus except for the plasma source 10A in Fig. 5, only a part of the wall 211 of the vacuum vessel 21 and the opening 213 are shown, and other structural elements are omitted.

The plasma source 10A includes the antenna 11A, the antenna fixing frame 12, a first insulation member 131A, a second insulation member 132A, the dielectric window 14, two radio-frequency current supply blocks 1511 and 1512, and the airtight holder 16. The configurations of the respective antenna fixing frame 12, dielectric window 14, and airtight holder 16 are the same as those in the first embodiment.

The first insulation member 131A is placed on the dielectric window 14, and has a frame shape in which the central part of a plate made of an insulation member is hollowed out. In the hollow space, the antenna 11A and the second insulation member 132 A are located.

The antenna 11A is a surface antenna made of a flexible metal sheet with the thickness of 500 µm. For such a sheet, metal foils made of copper, aluminum, and so on can be preferably used.

The second insulation member 132A is formed of an insulator having a substantially rectangular parallelepiped shape. The antenna 11A is provided to cover part of the faces of the second insulation member 132A, i.e. the bottom face 1323, two side faces 1322 and 1324 facing each other among the four side faces, and regions 1321 and 1325 each of which is a portion of the top face and connected to the corresponding one of the two side faces 1322 and 1324. In other words, the antenna 11A is provided to wrap around the second insulation member 132A from the region 1321 that is a portion of the top face connected to one side face 1322 toward the side face 1322, the bottom face 1323, the other side face 1324, and the region 1325 that is a portion of the top face connected to the other side face 1324. In this state, the bottom face 1323 of the second insulation member 132A is placed downward, and the antenna 11A and the second insulation member 132A are located in the hollow space of the first insulation member 131A, as mentioned earlier. Accordingly, a portion of the antenna 11A that wraps the bottom face 1323 of the second insulation member 132A faces the dielectric window 14, and portions of the antenna 11A that respectively wrap the side faces 1322 and 1324 of the second insulation member 132A face the first insulation member 131A and the antenna fixing frame 12 located outside the first insulation member 131A.

Spaces are respectively provided between the first insulation member 131A and the antenna 11A, and between the antenna 11A and the dielectric window 14 located below the antenna 11A, and the spaces are filled with an adhesive 134 made of silicone grease that is a resin serving as a dielectric member. Thermal contact between the first insulation member 131A and the adhesive 11A as well as between the antenna 11A and the dielectric window 14 is enhanced by the adhesive 134, in comparison with the case where these are directly in contact with each other.

Two radio-frequency current supply blocks 1511 and 1512 are fixed to the first insulation member 131A by respective bolts 154. Thus, the first insulation member 131A and the second insulation member 132A are connected via the radio-frequency current supply blocks 1511 and 1512.

The side of the first insulation member 131A is surrounded by the frame body 121 of the antenna fixing frame 12. A projection part 122 of the antenna fixing frame 12 abuts on a part of the top face of the first insulation member 131A. The first insulation member 131A, the dielectric window 14, and the airtight holder 16 are stacked, and the three stacked structural elements are sandwiched between the projection part 122 and the top face of the wall 211 of the vacuum vessel 21. The frame body 121 is fixed to the wall 211 by the bolts 123, so that the three structural elements are fixed to the wall 211. Sealing members (O-ring) 161 are provided between the dielectric window 14 and the airtight holder 16, and between the airtight holder 16 and the top face of the wall 211 of the vacuum vessel 21.

The two radio-frequency current supply blocks 1511 and 1512 are metal blocks, and one of them is connected to one electrode of the radio-frequency power source 26, and the other is connected to the other electrode of the radio-frequency power source 26 (the radio-frequency power source 26 is not shown in Fig. 5). One of the two blocks, the radio-frequency current supply block 1511, presses the antenna 11A to the second insulation member 132A on the top face of the second insulation member 132A so as to firmly hold the antenna 11A at the region 1321. The other one of the two blocks, the radio-frequency current supply block 1512, presses the antenna 11A to the second insulation member 132A so as to firmly hold the antenna 11A at the region 1325. The radio-frequency current supply blocks 1511 and 1512 respectively abut on the top face of the second insulation member 132A in a region other than the region where the antenna 11A is placed, and are fixed to the second insulation member 132A by respective bolts 153.

### (4) Operation of plasma source according to second embodiment

In a plasma processing apparatus provided with the plasma source 10A according to the second embodiment, processes similar to those performed in the plasma processing apparatus 1 according to the first embodiment are performed. Specifically, the substrate S is held by the substrate holder 24; the inner space 212 of the vacuum vessel 21 is evacuated, and then the plasma generating gas and the film-formation material gas are supplied from the gas supplier 23 to the inner space 212 of the vacuum vessel 21; and the radio-frequency current is introduced in the antenna 11A from the radio-frequency power source 26. With these processes, the radio-frequency electromagnetic field is generated in the inner space 212 of the vacuum vessel 21, and molecules of the plasma generating gas are ionized in the radio-frequency electromagnetic field, whereby plasma is generated. The molecules of the film-formation material gas, which are decomposed by the plasma, are deposited on the substrate S, to thereby form the film. The generation of the radio-frequency electromagnetic field in the inner space 212 of the vacuum vessel 21 is attributed by the portion of the antenna 11A that faces the inner space 212 and wraps the bottom face 1323 of the second insulation member 132A. Thus, the portion is understood as a surface antenna.

During the formation of the film, heat generated in the antenna 11A due to the flow of the radio-frequency current is released, as shown by the arrows in Fig. 6 through the second insulation member 132A and the radio-frequency current supply blocks 1511 and 1512 to the first insulation member 131A; through the radio-frequency current supply blocks 1511 and 1512 (without passing through the second insulation member 132A) to the first insulation member 131A; and through the adhesive 134 to the first insulation member 131A. The heat that thus released to the first insulation member 131A through a plurality of routs passes through the antenna fixing frame 12 and flows in the wall 211 of the vacuum vessel 21. As aforementioned, the wall 211 of the vacuum vessel 21 has an adequately large heat capacity, and the wall 211 is in contact with the ambient air, so that heat can be adequately released from the antenna 11A, and the antenna 11A is cooled. The periphery of the antenna 11A is surrounded by the antenna fixing frame 12, so that the heat generated in the antenna 11A can be efficiently released to the antenna fixing frame 12. In the present embodiment, portions of the antenna 11A that wrap the side faces 1322 and 1324 of the second insulation member 132A face the antenna fixing frame 12, so that the efficiency of transferring the heat of the antenna 11A to the antenna fixing frame 12 is further enhanced. Furthermore, the heat of the antenna 11A is radiated to the ambient air via the second insulation member 132A.

It is not necessary for the plasma source 10A according to the second embodiment to use a cooling mechanism for cooling the antenna 11A by the refrigerant, as in the first embodiment. Therefore, the initial cost and running cost of the apparatus is reduced.

Hereinafter, the results of the experiments are described. The experiments were conducted for verifying the cooling efficiency of the antenna and so on in the plasma source of the second embodiment. In the experiments, a temperature sensor was adhered to each of the antenna 11A, the first insulation member 131A, the second insulation member 132A, and the dielectric window 14, and the temperature change in each unit during the generation of the plasma was measured. In addition, other experiments were also conducted in terms of examples in which the space between the antenna 11A and the first insulation member 131A, and the space between the antenna 11A and the dielectric window 14 were not filled with the adhesive 134 (the spaces were left as they were). Here, the thickness of the spaces was 2 mm. The adhesive 134 was silicone grease. The pressure of the argon gas that is the plasma generation gas was 1.0 Pa, and the flow rate of the argon gas was 10 seem. The radio-frequency power supplied to the antenna 11A was 500W. The temperature of each unit was measured immediately after the lighting of the plasma (0 minutes), and at the respective time points of 5, 10, 15, and 30 minutes.

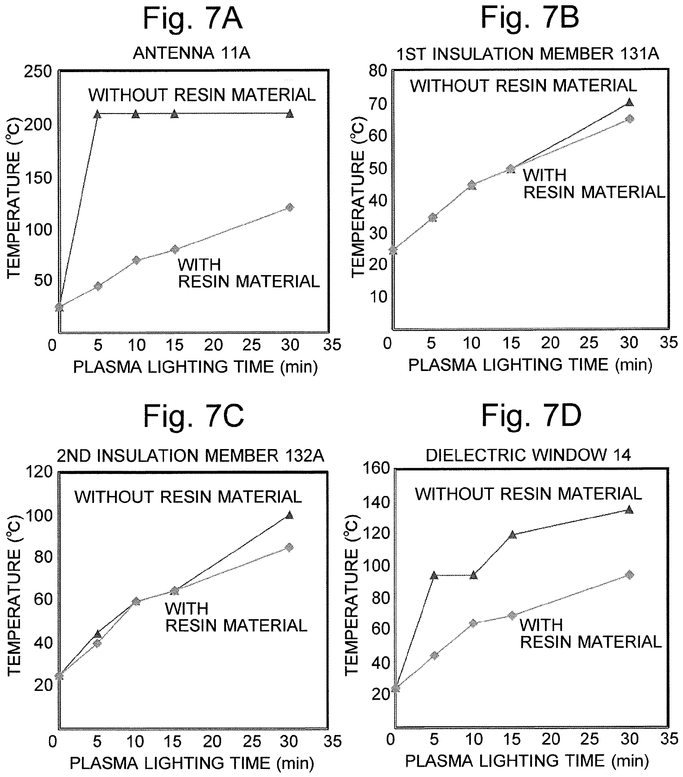

The measurement results are shown in Fig. 7. The comparison between a case where the space was filled with the adhesive 134 and a case where the space was not filled brings about the following. A clear difference in temperature was not observed between the first insulation member 131A and the second insulation member 132A, whereas a remarkable effect of decrease in the temperature rise was observed, for the antenna 11A and the dielectric window 14, in the case where the space was filled with the adhesive 134.

The plasma source according to the present invention is not limited to the embodiments mentioned earlier, and any change and modification can be added within the scope of the present invention.

### REFERENCE SIGNS LIST

- 1 ...: Plasma Processing Apparatus
- 10, 10A ...: Plasma Source
- 11, 11A ...: Antenna
- 110 ...: Stacked Body
- 12 ...: Antenna Fixing Frame
- 121 ...: Frame Body
- 122 ...: Projection Part
- 123 ...: Bolt for Fixing Antenna Fixing Frame to Wall of Vacuum Vessel
- 13 ...: Insulation Member
- 131A ...: First Insulation Member
- 132A ...: Second Insulation Member
- 1321, 1325 ...: Part of Top Face of Second Insulation Member
- 1322, 1324 ...: Side Face of Second Insulation Member
- 1323 ...: Bottom Face of Second Insulation Member
- 134 ...: Adhesive
- 14 ...: Dielectric Window
- 15 ...: Radio-Frequency Current Supply Bar
- 151 ...: Power-Feed Terminal
- 1511, 1512 ...: Radio-Frequency Current Supply Block
- 152 ...: Power-Feed Cable
- 153 ...: Bolt for Fixing Radio-Frequency Current Supply Block to Second Insulation Member
- 154 ...: Bolt for Fixing Radio-Frequency Current Supply Block to First Insulation Member
- 16 ...: Airtight Holder
- 161 ...: Sealing Member
- 21 ...: Vacuum Vessel
- 211 ...: Wall of Vacuum Vessel
- 212 ...: Inner Space of Vacuum Vessel
- 213 ...: Opening of Vacuum Vessel
- 22 ...: Vacuum Pump
- 23 ...: Gas Supplier
- 24 ...: Substrate Holder
- 25 ...: Substrate Carrying in/out Port
- 251 ...: Lid of Substrate Carrying in/out Port
- 26 ...: Radio-Frequency Power Source
- 27 ...: Impedance Matching Unit
- S ...: Substrate

## Claims

1. A plasma source that is a device configured to generate plasma in a vacuum vessel, the plasma source comprising:
a) a frame provided in a wall of the vacuum vessel, and
b) a surface antenna fixed in the frame.

2. The plasma source according to claim 1, wherein the frame is made of metal.

3. The plasma source according to claim 1 or 2, wherein the frame and the antenna are provided in a lid that closes an opening of the vacuum vessel.

4. The plasma source according to claim 3, further comprising a dielectric window that is a plate member made of a dielectric material and provided on a face of the antenna facing an inside of the vacuum vessel.

5. The plasma source according to claim 4, further comprising a vacuum seal located between the wall around the opening and the dielectric window.

6. The plasma source according to claim 4 or 5, wherein a space between the antenna and the dielectric window is filled with an adhesive made of a dielectric material.

7. The plasma source according to any one of claims 4 to 6, wherein the dielectric window has a thickness of 5 mm or less.

8. The plasma source according to any one of claims 3 to 7, further comprising an insulation plate provided on a face of the antenna facing an outside of the vacuum vessel, to be in contact with the frame, the insulation plate being a plate member made of an insulator.

9. The plasma source according to claim 8, wherein a space between the antenna and the insulation plate is filled with an adhesive made of a dielectric material.

10. The plasma source according to any one of claims 1 to 9, wherein the antenna has a thickness in a range from 1 to 1000 µm.
